# EUROPEAN PATENT SPECIFICATION

(11) **EP 1 746 622 B1**
(45) Date of publication and mention of the grant of the patent: **20.07.2011**
(21) Application number: 05727126.4
(22) Date of filing: 24.03.2005
(51) Int. Cl.: H01J 9/02, B81C 1/00

(54) **METHOD FOR FORMING CARBONACEOUS MATERIAL PROTRUSION AND CARBONACEOUS MATERIAL PROTRUSION**
VERFAHREN ZUR BILDUNG EINES KOHLENSTOFFHALTIGEN MATERIALVORSPRUNGS UND KOHLENSTOFFHALTIGER MATERIALVORSPRUNG
PROCEDE D'ELABORATION DE MATERIAU CARBONE SAILLANT ET MATERIAU CARBONE SAILLANT

(30) Priority: 29.03.2004 JP 2004096008; 31.08.2004 JP 2004253159
(43) Date of publication of application: 24.01.2007
(73) Proprietor: Sumitomo Electric Industries, Ltd., Osaka-shi, Osaka 541-0041 (JP)
(72) Inventor: NISHIBAYASHI, Yoshiki, Itami-shi, Hyogo 6640016 (JP); MIYAZAKI, Tomihito, Osaka 554-8511 (JP); HATTORI, Tetsuya, Yokohama-shi, Kanagawa 2448588 (JP); IMAI, Takahiro, Itami-shi, Hyogo 6640016 (JP)
(74) Representative: Cross, Rupert Edward Blount
(86) International application number: PCT/JP2005/005408
(87) International publication number: WO 2005/093775

(56) References cited:
- EP-A1- 0 836 217
- JP-A- 7 029 483
- JP-A- 7 094 077
- JP-A- 8 036 967
- JP-A- 8 195 165
- JP-A- 10 312 735
- JP-A- 2000 188 388
- JP-A- 2000 215 788
- JP-A- 2000 215 788
- JP-A- 2001 015 012
- JP-A- 2002 150 922
- US-A1- 2002 117 951

## Description

### Technical Field

The present invention relates to a method of forming a carbonaceous material projection.

### Background Art

There was the following conventional method for forming a diamond projection structure: diamond is grown on a depressed mold of silicon formed by anisotropic etching, and the silicon is removed to form pyramids of polycrystalline diamond (e.g., reference is made to Non-patent Document 1 below). However, where this method was applied to electron emitter devices, the projections thereof was made of polycrystalline because of a need for making grain sizes of tips small, and transport of electrons was not smooth because of existence of grain boundaries in the projections, posing the problem that electrons could not be efficiently emitted from the NEA surface. Where the method was applied to near-field probes, the following problem was posed: propagation of light was not smooth because of scattering of light caused by distortion of grain boundaries and individual crystals in polycrystalline material. It also raised a defect that angles of projections were not so sharp (approximately 70 degrees).

Then developed were a method of forming pyramids, using a single crystal, and a method of forming projections, which have various shapes (e.g., reference is made to Non-patent Document 2 below). This method is to form columns, the sizes of which are fine, on a surface of diamond and to epitaxially grow diamond on the columns while controlling parameters of the growth, thereby forming projections of pyramid shape each having a sharp-pointed tip. A method of further etching these column projections to sharpen them was also reported. Furthermore, a method of forming a 2-step candle-shape projection with an Al mask was also reported (e.g., reference is made to Non-patent Document 3 and Non-patent Document 4 below). Another prior art document (Non-patent Document 5) describes processing of diamond to form a projection.

EP 0 836 217 discloses a method for forming diamond projections.
Non-patent Document 1: K. Okano, K. Hoshima, S. Koizumi and K. Nishimura, "Diamond and Related Materials 5" (1996) 19-24
Non-patent Document 2: Y. Nishibayashi, H. Saito, T. Imai and N. Fujimori, "Diamond and Related Materials 9" (2000) 290-294
Non-patent Document 3: Yoshiki Nishibayashi, Yutaka Ando, Hiroshi Furuta, Koji Kobashi, Kiichi Meguro, Takahiro Imai, Takashi Hirao and Kenjiro Oura "SEI Technical Review (August 2002)"
Non-patent Document 4: Yoshiki Nishibayashi, Yutaka Ando, Hiroshi Furuta, Natsuo Tatsumi, Akihiko Namba and T. Imai, "Sumitomo Electric Industries Technical Review, No. 57" (2004) 33-36
Non-patent Document 5: E. S Baik, Y J. Baik and D. Jeon, "Thin Solid Films 377-378" (2000) 299-302

### Disclosure of the Invention

### Problem to be Solved by the Invention

The candle-shape projection has a high aspect ratio and is a strong candidate of shapes for forming projections in a very high density and with a tip pointed at an extremely acute angle. However, each projection was 1 µm square at best, and it was difficult to form smaller projections than those when the same method was used and it was infeasible to form projections of uniform shape with accuracy in actual formation. Namely, it was never applicable to a solution to the following problems: each projection is made of single crystal, projections are lined up well, projections are extremely uniform within 10%, the tips thereof have an acute angle (45 degrees or less), the aspect ratio is high, a substrate has a flat surface except for the projections, four or more projections are formed in 1 µm square, and so on.

Use of Al for formation of the candle-shape projection has already been known, but the performance for solving the above problems was definitely poor. Use of another material as a mask makes it difficult to form a sharp tip as shown in Non-patent Document 5. A fine mask pattern with high accuracy is needed in order to enhance the accuracy of the diameter of fine tips. There is no precedent for a mask having arrayed patterns each size of which is not more than 300 nm, and a mask having arrayed patterns each size of which is not more than 50 nm is completely unknown. Furthermore, no method is available for satisfying the conditions that heights of projections are uniform within 10% and that four or more projections are formed in 1 µm square.

An object of the present invention is to provide a method of forming a carbonaceous material projection structure, in which a minute, accurate, microscopic mask for satisfying the following conditions can be formed: a projection is formed in a carbonaceous material substrate such as a diamond substrate and the projection has a fine tip; the projection tip has an acute angle; the aspect ratio of the projection is high; and the substrate has a flat surface except for the projection, and to provide a carbonaceous material projection structure.

### Means for Solving the Problem

In view of the foregoing problem, the Inventors have found use of a mask having a conical, fine pattern as a mask for diamond for obtaining an extremely fine and acute projection. The present invention is accomplished based on this teaching.

The present invention provides a method of forming are or more carbonaceous material projections according to claim 1 of the claims appended hereto.

According to the method of the present invention, the mask material is deposited through the aperture of each hole that is formed so as to be inversely tapered from its aperture toward its bottom, and thus the mask deposition with a projection tip of an acute angle and with a high aspect ratio is regularly formed.

In the method of forming the carbonaceous material projection of one aspect of the present invention, it is preferable that the carbonaceous material projections be arranged according to a predetermined arrangement rule, each of the carbonaceous material projections has a projected diameter of not more than 300 nm, and a density of the carbonaceous material projections is not less than 4 projections/µm².

In the method of forming the carbonaceous material projection of one aspect of the present invention, it is preferable that the carbonaceous material projection be of a conical shape.

### Effects of the Invention

It can be understood from the principle of fabrication that the carbonaceous material projection structure of the present invention has the extremely high uniformity of projection height. Since the apical position of each projection has no deviation from the center axis of its projection, the projections can be formed with good reproducibility in fabrication of devices. Furthermore, since the projections are of the small size, it is applicable to fabricate emitters in which the projections are arranged in a high density, and the current density can be made larger than before. In addition, it is possible to achieve the large aspect ratio and the high density of the projections. The projection structure is characterized by the accuracy of the center axis of each tip and extremely small variation of height, and thus demonstrates significant effect in electron emission characteristics. Such uniform projections can be important components, particularly, in electron emitter devices, atomic probes, and near-field probes. Such electron emitter devices are applicable to electron guns, electron tubes, vacuum valves, field emission displays (FED), and so on. The atom probes and near-field probes described above are applicable to STM, AFM, SNOM, etc. and electron equipment using the principles of these devices.

### Brief Description of the Drawings

The above object and other objects, features, and advantages of the present invention will become apparent more easily from the following detailed description of the preferred embodiments of the present invention with reference to the accompanying drawings.
Fig. 1 includes part (a), part (b), and part (c) as views for explaining a method of forming a minute-projection mask according to an embodiment of the present invention.
Fig. 2 includes part (a) and part (b) as views for explaining a method of forming a minute-projection mask according to an embodiment of the present invention.
Fig. 3 includes part (a), part (b), part (c), part (d), part (e), part (f), and part (g) as views for explaining another method of forming a minute-projection mask according to a reference Example.
Fig. 4 includes part (a) and part (b) as views for explaining a projection formed by a minute-projection mask according to a reference Example.
Fig. 5 is a drawing for explaining projections formed.
Fig. 6 is a drawing for explaining projections formed and characteristics thereof.
Fig. 7 is a drawing for explaining projections formed.
Fig. 8 includes part (a), part (b), and part (c) as views for explaining projections formed.
Fig. 9 is a drawing for explaining projections formed.
Fig. 10 is a drawing for explaining projections formed.
Fig. 11 is a drawing for explaining projections formed and characteristics thereof.
Fig. 12 is a drawing for explaining conditions for forming the projections.
Fig. 13 is a drawing for explaining projections formed and characteristics thereof.

### Description of Reference Symbols

10...diamond substrate; 11, 16...resist; 12...hole; 13...metal; 14... deposition; 15 ... silicon nitride film or silicon nitride oxide film

### Best Mode for Carrying out the Invention

The teaching of the present invention can be readily understood in view of the following detailed description with reference to the accompanying drawings presented by way of illustration only. Subsequently, embodiments of the present invention will be described with reference to the accompanying drawings. When possible, parts identical to each other will be referred to with symbols identical to each other.

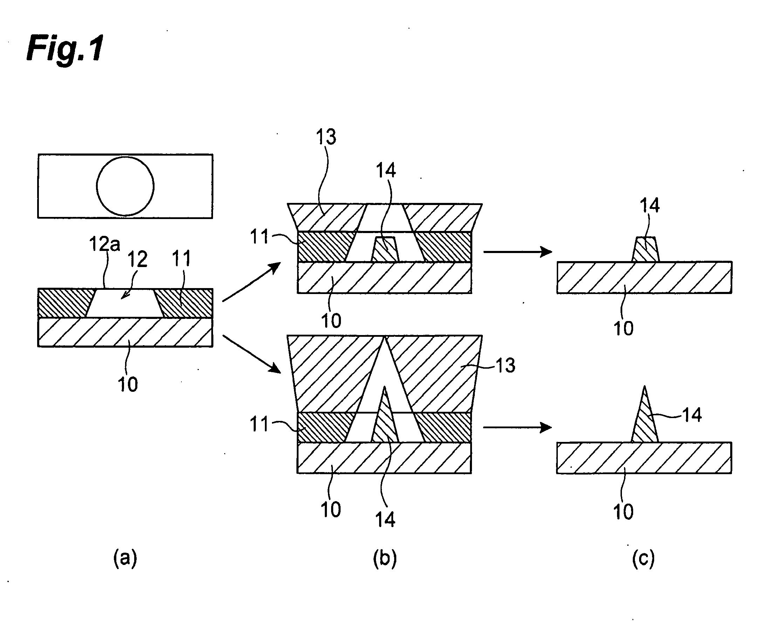

A method of forming a carbonaceous material projection according to an embodiment of the present invention will be described. As shown in part (a) of Fig. 1, a resist 11 (photoresist or electron beam resist) is applied onto a diamond substrate 10 and a fine hole 12 is made in the resist so that a sidewall surface 12b of the hole 12 is slightly inversely tapered from an aperture 12a toward a bottom 12c. Since positive resists makes it easy to inversely taper the sidewall surface, electron beam resists are suitably applicable.

Thereafter, as shown in part (b) of Fig. 1, a metal 13 (mask material) is deposited by evaporation. A film thickness of the metal 13 is smaller than the thickness of the resist film. In this case, if the metal is deposited until closing the hole 12, a deposited material 14 (mask deposition) is formed in the hole 12 and the shape of the deposited material 14 is an approximately conical column (see the lower part in part (b) of Fig. 1). The evaporation may be stopped before closing the hole 12, and in that case the shape of the deposited material 14 is a circular truncated cone (see the upper part in part (b) of Fig. 1). Thereafter, the resist 11 is detached or removed with solution for removing resist to form a mask having regularly arranged projections. The mask is preferably made of material that is not etched with the removing solution or the like.

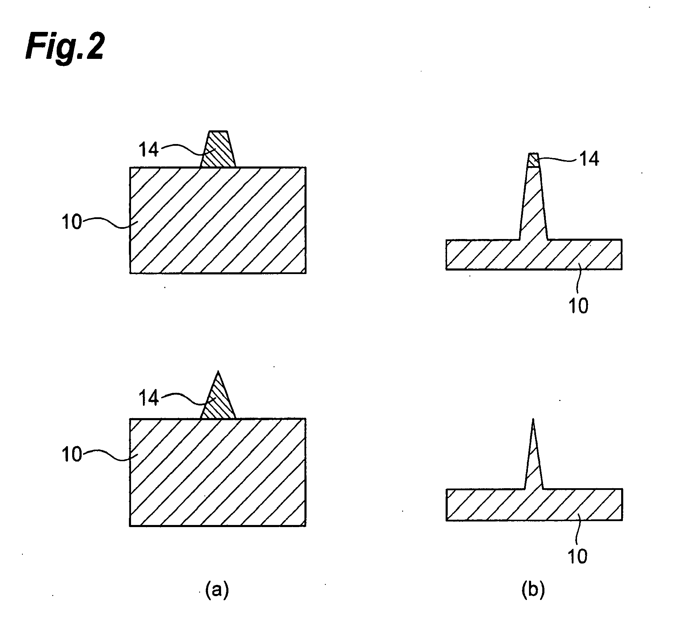

After that, diamond is etched using a mask consisting of the deposition of the circular cone or circular truncated cone (see part (a) of Fig. 2). As a result, a conical small column of diamond (carbonaceous material projection) can be formed (see part (b) of Fig. 2). The significant point herein is that the shape of the mask is a circular cone or circular truncated cone, and the mask shape is transferred to form a conical projection of diamond or the like. The etching selectivity of the mask material and diamond should preferably be large because each projection becomes tall and can be formed as a sharp one.

For example, the mask material can be made of Au, Mo, W, and so on. However, the etching of diamond needs to use a gas containing oxygen. In the use of a gas containing a large amount of Ar or N₂, the content of Ar or N₂ (flow rate) should preferably be less than 10% (e.g., oxygen: 100 sccm, Ar or N₂: 10 sccm) because the mask material is etched to become small soon, the selectivity cannot be large, and the angle of the projection cannot be a small value of not more than 45 degrees.
A resist for lift-off can be formed directly on the diamond, but a layer of metal or the like for undercoat may be formed between them. Use of this undercoat layer is effective in avoiding charge-up because of low conductivity of the diamond. It is important to avoid charge-up in order to obtaining high accuracy of microprocessing. Use of the undercoat layer might improve adhesion between the diamond and the projection material for the mask. However, the undercoat metal has to be removed after the formation of the projections.

Accordingly, it is needed to meet the condition that the undercoat material has to be removed without removing the mask material. This condition is satisfied by use of Au for the mask material and Ti or Mo for the undercoat material. It is preferable to use a good chemical resistant material like Au or Pt for the mask material. Since the mask material is formed by lift-off, it can be basically made of usual materials.

The mask material can also be a silicon oxide (e.g., SiO₂ or SiOₓ), a silicon nitride oxide (e.g., SiOₓN_{y}), or a silicon nitride (e.g., SiNₓ). A preferred method of forming these mask materials is an EB evaporation method or the like. Preferred ranges for the subscripts are shown as follows: x in SiOₓ is 0 < x < 2; x and y in SiOₓN_{y} are x = z × x1 and y = (1 - z) × y1, 0 < x1 < 2,0 <y1 < 1.33, and 0 < z < 1; x in SiNₓ is 0 < x < 1.33.

A method of forming the present projection mask will be described below with specific examples of the mask material. As shown in part (a) of Fig. 1, the resist 11 is first applied onto the diamond substrate 10 and the tapered hole 12 is made by electron beam exposure. Then, the metal 13 of Au or Mo is formed by deposition method and has a shape gradually narrowed toward the tip (see part (b) of Fig. 1). This forming method allows formation of an extremely small projection (equal to or less than 300 nm) and such a size has not been achieved before.

There is no precedent study on using the metal 13 as a mask for etching of diamond or the like. The mask including an extremely pointed projection(s) is suitably applicable for forming a diamond projection(s) below it. In addition, it is important that the angle of the projection of the diamond be controllable through adjustment of the selectivity even if the projection angle is small.

The diamond was etched in oxygen gas containing a small amount of CF₄ and using a mask with an array of microprocessed projections, to form projections each having a tip of a size smaller than the pattern size of the mask (see part (b) of Fig. 2). The projections of diamond thus produced had the aspect ratio of not less than 2 with a thin tip, and the heights of the projections were high. The tip of each diamond projection thus formed was approximately centered, the location accuracy of the central part of each projection was excellent, and the height uniformity of the projections was also excellent.

The size of the present diamond projections is dependent on the pattern size of the mask, and the size of projections can be reduced as small as a few micrometers. However, it should be noted that a projection having its maximum diameter equal to or less than 300 nm can be formed. The reason will be described below.

Supposing a mask with its tip of not more than 100 nm should be formed by etching a mask of 1 µm size, the pattern size accuracy would be degraded gradually during the etching of the mask. Even if the etching accuracy were better than 10%, there would arise variation equivalent to that of the tip diameter. For obtaining the accuracy better than 5%, it is necessary to achieve the etching accuracy better than 0.5%. This is difficult in practice.

On the other hand, when the pattern size of the mask is equal to or less than 300 nm, the variation is 30% for formation of the tip of 100 nm even if the etching variation is 10%; accordingly, the variation of 3% can be realized when the etching variation is 1%. A desired projection can be realized. Therefore, the pattern of the mask for the present emitter is equal to or less than 300 nm.

When diamond is etched using the mask having pattern of a projection shape as described above to form a diamond projection, its pointed tip can be extremely thin, and its location accuracy is extremely high even though the total width thereof is smaller than 300 nm.

Since the aspect ratio (height/diameter) of the projection mask relates to the etching selectivity, it can be used as a mask even if the aspect ratio thereof is low. The aspect ratio of the diamond projection formed is preferably equal to or more than 2.

Projections of small size were actually formed as follows: diamond projections were formed with a mask in the diameter of 150 nm, and the projections formed had the thickness of 150 nm and the tip diameter of not more than 10 nm. These fine projections were formed in the density of 4 projections per 1 µm square.

In the present method, since the selectivity of the diamond and the projection material can be large, the projection with an extremely high aspect ratio can be formed. This method is a technology capable of forming the extremely small pattern size of the mask of not more than 100 nm, and thus, even if the etching is stopped prior to removing the mask by the etching and the mask is left at the tip of the diamond projection formed, a diamond column as the diamond projection can be formed and has an extremely small tip, the tip is not more than the size of the mask pattern, and the variation of height can be made as small as the surface roughness of the substrate.

Next, the reason why it is important to make the emitter density higher will be described below. When projections having the diameter of 1 µm are formed, the emitter height is at least 2 µm or more, and the emitter density is at most 250,000 emitters/mm² in consideration of the projection spacing. Supposing an electric current stably emitted from each emitter is 0.1 µA, the current density is estimated to be 25 mA/mm². This value is small, when compared with the emission current density of approximately 100 mA/mm² from the conventional emitters using a hot-cathode material.

However, where the projections of the diameter of not more than 300 nm are formed, the projection spacing can be made as small as about 500 nm and the emitter density can be raised to 1,000,000 emitters/mm² or more. Then, the current density is estimated to be equal to or more than 100 mA/mm², and it becomes feasible to form devices the current density in which is not less than that in the conventional emitters. Accordingly, forming the emitters in the density of four or more in 1 µm square leads to capability of providing significant devices on reaching the above density. There was nothing proposed heretofore about the method of forming the emitters in such a density. Furthermore, if the diameter of the projections is not more than 200 nm, the density is estimated to be not less than 6.25 projections in 1 µm square and it is clearly effective.

Here the diamond emitters refer to projections with a high aspect ratio arrayed regularly. The reason is as follows. In the case of emitters of a structure using gate electrodes, projections with a low aspect ratio of not more than one have a large capacitance between the projections and the substrate and the large capacitance hinders highfrequency operation of the emitters. In the case of the emitters the gates of which are fabricated by self-alignment, it becomes difficult to make holes around the emitters if the aspect ratio of the projections is low. It is also undesired to use emitters where the projections are located at random because these random emitters cannot avoid local concentration of current (does not allow the design of uniform current distribution), and this is a hindrance to providing emitters with emitting of a large amount of current.

The emitters as described above can be obtained by processing diamond by dry etching using oxygen with the mask of the present embodiment.

In order to realize the fine projections, the substrate needs to have extremely good flatness. The desired flatness can never be achieved by as-deposited polycrystalline diamond. It is understood from the size, 1 µm, of projections to be formed that the flatness needs to be smaller than 100 nm. Since the projections having the size of 200 nm can be formed, the flatness preferably needs to be smaller than 20 nm. Since it is possible to obtain a substrate which has the flatness of several nm, use of this substrate is useful therefor. The substrate with such flatness can be more readily formed from a single crystal, but it may be made of polycrystalline.

Furthermore, each projection itself is preferably made of a single crystal because carriers need to reach the tip of the projection column without annihilation. The single crystal is preferable rather than polycrystals for the projections of the sizes heretofore, and this reason is that grain boundaries of crystal should not be included in the projections. However, since the projections of the present invention are very small, the substrate may be made of a polycrystalline one. For the above reason, grain sizes of the poly crystal are preferably larger than sizes of the projections. For the same reason, a highly oriented polycrystalline diamond is more desirable than a randomly oriented polycrystal except for the single crystal substrate, and a heteroepitaxial substrate is much more preferable than the highly oriented polycrystalline diamond.

The above description can also apply to carbonaceous materials with extremely high flatness (flatness of not less than 100 nm, preferably, not less than 20 nm), e.g., DLC, a-CN film, a-C film, CNT/SiC, and graphite/SiC, in addition to the diamond substrates.

The usefulness of forming the fine projections in the size of 300 nm and in the high density of not less than 4 projections per 1 µm square has been described with reference to a forming method using the lift-off. Subsequently, we will describe a method of forming a carbonaceous material projection in which a mask is formed by etching process without the use of a lift-off process. This method does ot form part of the present invention.

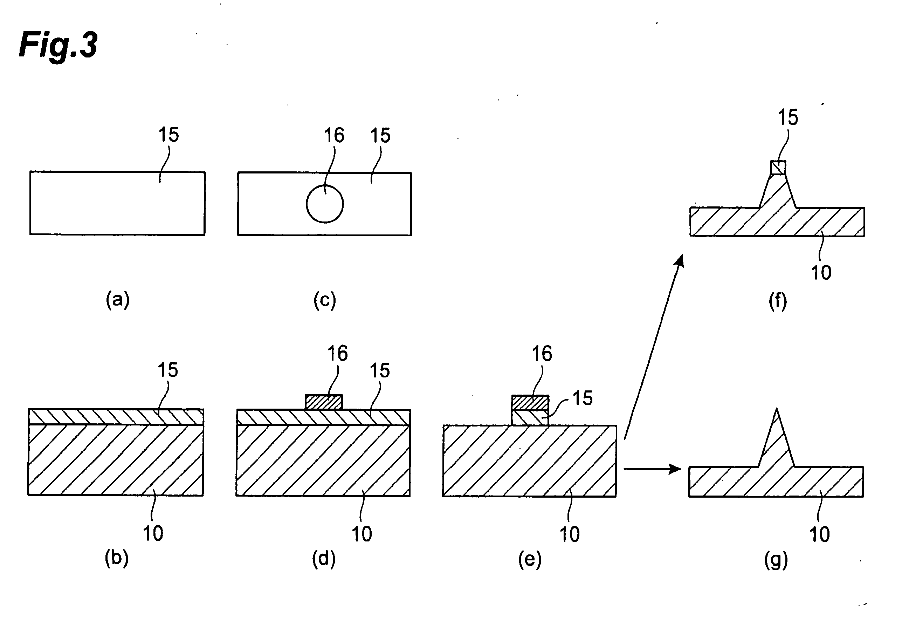

First, as shown in part (a) (plan view) of Fig. 3 and in part (b) (sectional view) of Fig. 3, a silicon nitride film (or silicon nitride oxide film) 15 is deposited on a diamond substrate 10. The silicon nitride SiNₓ can be used for the film 15 where 0 < x < 1.33; silicon nitride oxide SiOₓN_{y} can be used for the film 15 where x = z × x1, y = (1 - z) × y1, 0 < x1 < 2, 0 < y1 < 1.33, and 0 < z < 1. z is particularly preferably not less than 0.3. The film 15 may be deposited by PVD (physical vapor deposition or sputtering) such as EB evaporation, and it is more preferably deposited by CVD (chemical vapor deposition), in terms of uniformity, controllability, and forming rate.

After that, as shown in part (c) (plan view) of Fig. 3 and in part (d) (sectional view) of Fig. 3, a resist (photoresist or electron beam resist) is applied onto the film 15, and a patterned resist 16 is formed by photolithography or by electron beam exposure and has a dot (which is preferably a substantially circular shape, but may be any other shape). At this time, a plurality of dots in the patterned resist 16 are provided according to a predetermined arrangement rule. Thereafter, as shown in part (e) of Fig. 3, the film 15 is processed by dry etching by use of the mask 16 having the pattern of the dot shape. The etching gas preferably applicable is CF₄, CHF₃, C₂F₆, SF₆ gas, or the like. The three-dimensional shape of the film 15 as etched to form a dot is a circular cylinder in the present embodiment, but may be a circular cone or circular truncated cone.

Thereafter, the diamond substrate 10 is etched using a mask including the dots formed by etching the film 15. This results in forming conical small projections of diamond (carbonaceous material projections) (see part (f) of Fig. 3 and part (g) of Fig. 3). As shown in part (f) of Fig. 3, the etching may be stopped before the film 15 is completely removed. Then, the carbonaceous material projections are formed in a circular truncated cone. As shown in part (g) of Fig. 3, the etching may be conducted until the film 15 is completely removed. Then, the carbonaceous material projections are formed in a circular cone with a pointed tip.

The Inventors have further found that a fine, acutely pointed projection is formed if the following two conditions are met: an extremely fine mask can be formed with high accuracy; etching of the carbonaceous material can be controlled in the vertical lateral directions of the mask material in etching the carbonaceous material (diamond in the present embodiment). Then the Inventors have found that silicon nitride film (SiNₓ film) or silicon nitride oxide film (SiOₓN_{y} film) can be used for diamond as material of the mask satisfying the above two conditions. According to experiments by the Inventors, the silicon oxide film (SiOₓ film) failed to satisfy the two conditions.

The Inventors presumes that the above silicon nitride film and silicon nitride oxide film satisfy the two conditions because advantageously acting factors are as follows: they have a low transmittance for ultraviolet light; and they are amorphous. Namely, the photolithography technology utilizes sensitivity to ultraviolet light to perform the fine patterning, and if the mask material is transparent to ultraviolet light, the ultraviolet light will leak to adjoining regions, to degrade the accuracy of patterning. In contrast to it, the silicon nitride film and silicon nitride oxide film have a low transmittance for ultraviolet light, so that the patterning can be performed with high accuracy. Since the silicon oxide film is transparent to ultraviolet light, it is difficult to implement a fine patterning.

In addition to the above, other important conditions for the mask material are as follows: an etching selectivity to the diamond is obtained (i.e., the etching rate of the mask material is smaller than that of diamond); a high etching selectivity to the resist is obtained (i.e., the etching rate of the mask material is sufficiently larger than that of the resist). SiO₂ as a mask material for diamond satisfies the former condition but fails to satisfy the latter condition. On the other hand, the Inventors have discovered that the silicon nitride film and silicon nitride oxide film of the aforementioned compositions satisfy these conditions and can be used as very good masks.

A further condition is that amorphous material is used for the film for the mask material. When the mask material is crystalline, the etching rates for the mask become anisotropic, and it becomes difficult to uniformly form the size and shape of the mask pattern. Another reason therefor is that crystalline materials contain grain boundaries therein. When the mask material is amorphous, the mask can be patterned in uniform size and shape because of no grain boundaries. The silicon nitride film and silicon nitride oxide film of the aforementioned compositions satisfy the above condition.

As described above, the silicon nitride film and silicon nitride oxide film of the foregoing compositions are advantageous in that they can be dry-etched using a resist mask. The Inventors have found the condition for enabling the etching of the silicon nitride film and silicon nitride oxide film of the foregoing compositions in the oxygen gas containing CF₄, and these silicon nitride film and silicon nitride oxide film satisfy the condition that the film can be etched using the resist mask. The patterning of resist may be performed by photolithography technology or electron beam lithography technology. With either of these technologies, it is feasible to make the pattern size of the resist mask uniform and to form a desired array of patterns, and thus the silicon nitride film and silicon nitride oxide film are useful. On the other hand, the SiO₂ film does not provide a large selectivity of the resist and SiO₂ film even by use of dry etching (i.e., the etching rate of the SiO₂ film is not sufficiently larger than that of the resist). Therefore, it is infeasible to pattern it except for very thin films. In addition, it is infeasible to form a mask of circular cylinder shape. According to the Inventors' experiment, such masks cannot be used to form no acute carbonaceous material projections.

Most of metals can be etched using a resist mask, and thus satisfy the above condition (a large selectivity of the metal and resist is secured), but these metals fail to satisfy the condition described below.

In the etching process using a mask consisting of the silicon nitride film and silicon nitride oxide film of the foregoing compositions, the mask is laterally etched in etching the carbonaceous material such as diamond, and the shape of the mask is changed into circular cone shape or circular truncated cone shape. Therefore, the projections of diamond can be processed into circular cone shape or circular truncated cone shape. Since the etching rate of the mask is not larger than that of diamond, the diamond projections can be formed in the conical shape with an acute angle at its tip. The apex angle and the height of the projection can be controlled through adjustment of etching conditions. As described above, the Inventors' experiment has found that with the use of the silicon nitride film or silicon nitride oxide film, even if an initial shape of the mask is of a circular cylinder shape, the mask itself is laterally etched during the etching of the diamond and the diamond projection is formed in conical shape. In contrast to it, masks of many metal materials are not etched laterally during the etching of diamond, and the diamond projections have a circular cylinder shape by the production process shown in Fig. 3. However, if a metal mask is formed in conical shape by lift-off as shown in Fig. 1, the diamond projection can be formed in circular cone shape or circular truncated cone shape as if lateral etching of the carbonaceous material (diamond substrate 10) were apparently caused.

When the mask of SiN was used in practice in formation of diamond projections of small size, the following diamond projections were formed as described later in Examples: the tip diameter is not more than 40 nm; the vertex angle is not more than 32 degrees; the height uniformity of projections is not more than ±3%. Then such small projections were formed in the density of four projections in 1 µm square. When the mask of SiON is used, the following diamond projections were formed as described later in Examples: the tip diameter is not more than 50 nm; the apex angle is not more than 39 degrees; the height uniformity of projections is not more than ±5%. Such small projections were formed in the density of 4 projections in 1 µm square.

As described above, even with the mask of cylindrical shape, the carbonaceous material projection production method by use of the mask consisting of the silicon nitride film or silicon nitride oxide film is able to form the fine diamond projections satisfying the following: excellent locational and dimensional accuracy; extremely acute tip. Since an etching rate ratio between the mask and diamond can be controlled through the adjustment of etching conditions in the etching of diamond, the vertex angles of cones of diamond projections can be controlled using a mask having a side inclined with an arbitrary angle. According to the Inventors' experiment, it was not easy to etch SiO₂ with the use of the resist mask and when it was forcedly etched, the inclination of the mask side of SiO₂ became too large. It is hard to use such diamond projections for emitters and this reasons are as follows: the lateral etching rate to diamond is too large; because of the large etching rate, large-height and small-diameter diamond projections cannot be formed; the vertex angles of the diamond projections formed are very large (e.g., 44 degrees or more). For these reasons, the silicon nitride film and silicon nitride oxide film permitting formation of diamond projections with a small vertex angle are suitable as mask materials.

### Example 1

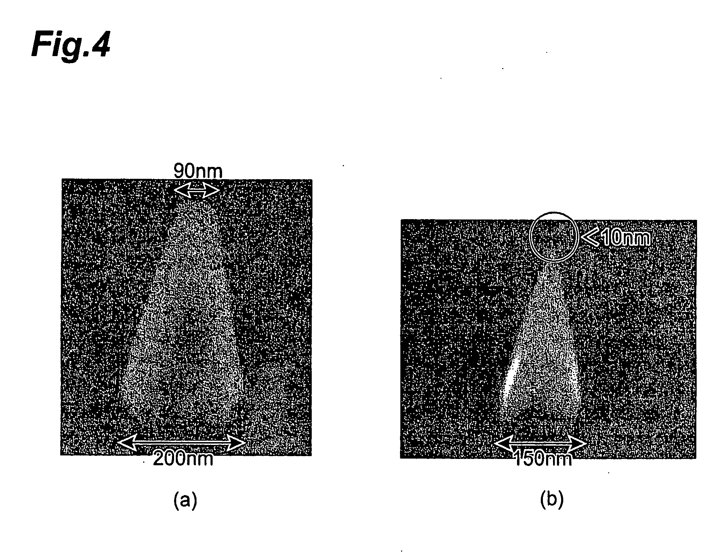

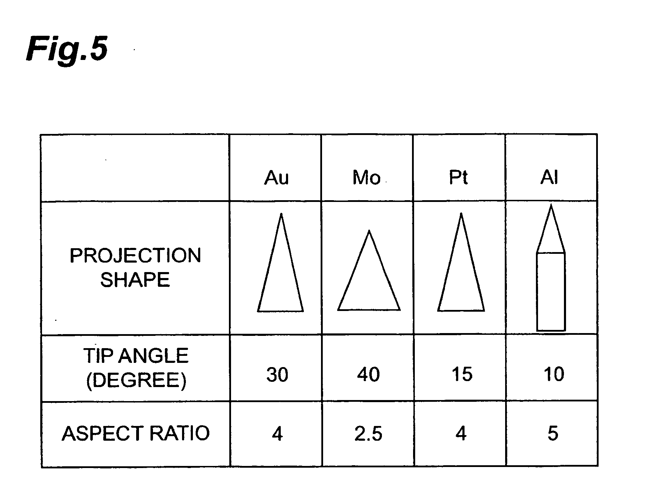

A high-pressure-synthesized single-crystal diamond substrate (100) and a CVD polycrystalline diamond wafer substrate were planarized to not more than several nm by polishing to prepare substrates, the prepared substrates were coated with resist for electron beam lithography, electron beam exposure was conducted, and holes of inversely tapered shape were formed (cf. part (a) of Fig. 1). Then ,a metal film of one of Au, Mo, Pt, and Al was deposited on them, and the resist was removed thereafter to lift off the metal film (cf. part (c) of Fig. 1). Diamond etching was performed using the mask, whereby extremely acute diamond projections were formed as shown in part (a) of Fig. 4 and in part (b) of Fig. 4. Part (a) of Fig. 4 shows a projection shape formed by use of a circular truncated cone mask or a projection shape formed by use of a circular cone mask and by stopping the etching before complete removal of the mask. Part (b) of Fig. 4 shows a projection of a pointed shape formed by etching the circular cone mask to the last. In this experiment, extremely fine acute projections were formed. The projections were formed in much the same shape though the angles of the projections are different from each other depending upon materials of the projections. Fig. 5 shows a summary of the kinds of metals and the shapes formed.

Since projections of the masks were formed in similar shape, the diamond projections were also formed with little variation in accuracy. When etching was stopped midway with the mask being left, the projections were formed with very small variation in height (equivalent to the level corresponding to roughness of the substrate) though the tip diameter was large.

There is no difference of projections due to the difference between the substrates, the single-crystal substrate and polycrystalline wafer substrate, except that the etched surface was flatter in the single-crystal substrate.

### Example 2

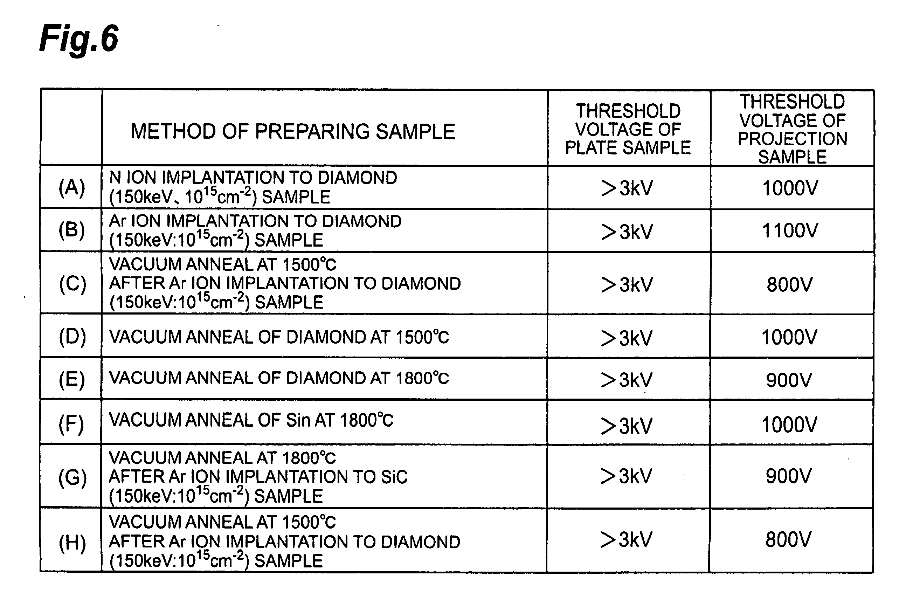

A high-pressure-synthesized single-crystal diamond substrate (100), a CVD polycrystalline diamond wafer substrate, and a SiC substrate were planarized to not more than several nm by polishing to prepare substrates. Each of these prepared substrates was implanted with ions of inert gas or nitrogen to prepare a sample. Some of these samples were treated by high-temperature anneal (1500°C or 1800°C) in vacuum, and the rest of these samples and samples not subjected to the ion implantation were processed at high temperature. On a surface of each of these samples, a black layer of electrically conductivity, which may be assumed to be graphite, was formed. A patterned mask of a projection shape was formed on the samples by the same method as in Example 1. The carbonaceous material was etched using them as masks, whereby extremely acute projections of the carbonaceous material were formed as shown in part (a) of Fig. 4 and in part (b) of Fig. 4. The carbonaceous material from the surface was removed by the etching, and thus an electrically conductive carbonaceous material was again formed by the same method as above. A coating of metal (Al) was formed in some of the samples. Fig. 6 shows a summary of the obtained samples and electron emission characteristics. As shown in Fig. 6, the measurement results reveal that there was a clear difference in the electron emission characteristics between those with and without the projections of the electrically conductive carbonaceous material and shows that the formation of projections is significant. In Fig. 6, rows (A) to (G) represent the samples with the formation of the electrically conductive carbonaceous material, the formation of projections, and the formation of the electrically conductive carbonaceous material, and row (H) represent the sample with the formation of the electrically conductive carbonaceous material, the formation of projections, and the formation of the Al coating (tip exposed). The electrode spacing was 100 µm.

### Example 3

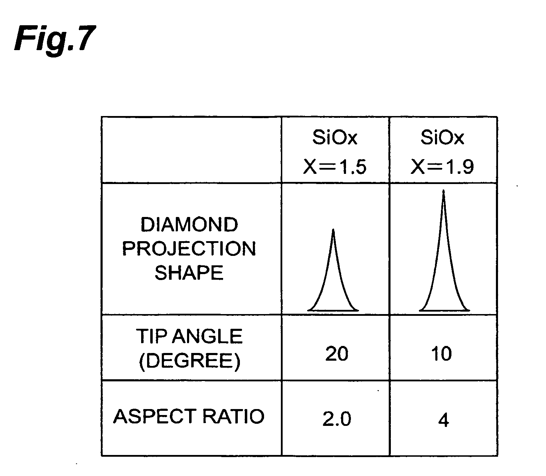

A high-pressure-synthesized single-crystal diamond substrate (100) and a CVD polycrystalline diamond wafer substrate were planarized to not more than several nm by polishing to prepare substrates, they were coated with resist for electron beam lithography, electron beam exposure was conducted, and holes of inversely tapered shape were formed (cf. part (a) of Fig. 1). A SiOₓ film was deposited thereon with a source material of SiO₂ by the EB evaporation, the resist was removed thereafter, and the SiOₓ film was lifted off (cf. part (c) of Fig. 1). The composition of the SiOₓ film was close to SiO₂ where a small amount of oxygen gas was introduced into the SiOₓ film. Where it was processed in inert gas or in high vacuum, the oxygen content was small in the film. The compositions are presented in Fig. 7. When diamond was etched using this mask, diamond columns with an extremely acute tip were formed. It was demonstrated that the diamond projections were formed using the mask of such materials as above except for the metal mask as in Example 1. It was demonstrated that the aspect ratio and angle of the projections were able to be controlled by the composition rate of x in the SiOₓ film. Fig. 7 shows the shapes of the projections. In use of this mask, there was no significant difference of projections due to the difference between the substrates, the single-crystal substrate or the polycrystalline wafer substrate.

### Example 4 (A Reference Example not forming part of the present invention)

A high-pressure-synthesized single-crystal diamond substrate (100) and a CVD polycrystalline diamond wafer substrate were planarized to not more than several nm by polishing to prepare substrates, and a silicon nitride oxide film (SiON film) or silicon nitride film (SiN film) was deposited (in the thickness of 0.2-1.0 µm) on each of the substrates by CVD or by sputtering. Then a resist was formed on the film and patterned by photolithography or by electron beam exposure. As a sample for comparison, a silicon oxide film (SiO₂ film) was formed on a substrate and a resist was formed thereon and patterned to prepare a sample. Another substrate prepared was a carbonaceous material substrate such as a carbon nano tube (CNT)/SiC substrate different from the above substrates, a SiON film was also formed on this substrate, and a resist was formed on the film and patterned. Next, using the resist mask, each of the SiON film, SiN film, and SiO₂ film was etched with CF₄, CHF₃, C₂F₆, or SF₆ gas to form a mask for etching of the substrate. With any one of these gases, masks having circular cylinder dots were formed well with good accuracy from the SiO film and SiN film. However, it was difficult to form circular cylinder dots with accuracy from the SiO₂ film.

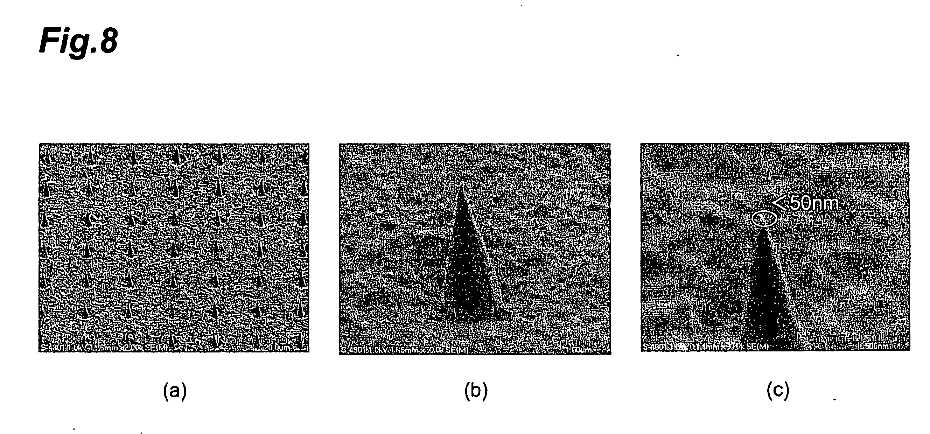

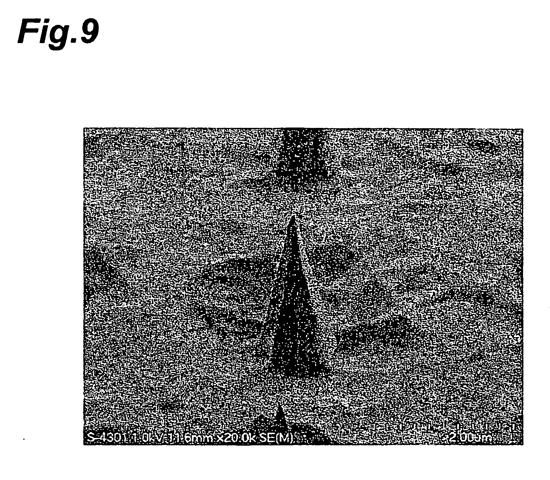

Then the diamond wafer substrate and CNT/SiC substrate were etched using the mask of circular cylinder dots. Using the mask made of the SiN film or SiON film, the substrate was etched by RIE (power density: 0.04-0.05 W/mm², pressure: 1-5 Pa) with O₂ and CF₄ gas (CF₄/0₂ = 1%), whereby carbonaceous material projections of extremely fine, acute (the tip diameter ≤ 50 nm) conical shape were formed as shown in parts (a) to (c) of Fig. 8 and in Fig. 9. Part (a) of Fig. 8 shows an SEM photograph showing a plurality of carbonaceous material projections arranged according to a predetermined arrangement rule, and this carbonaceous material projection structure is formed using the mask of SiN_{1.3}. Part (b) of Fig. 8 shows an SEM photograph showing an enlarged one of the plurality of carbonaceous material projections shown in part (a) of Fig. 8. Part (c) of Fig. 8 shows an SEM photograph showing a further enlarged tip part of the carbonaceous material projection shown in part (b) of Fig. 8. Fig. 9 is an SEM photograph showing a carbonaceous material projection formed using the mask of SiO_{0.2}N_{0.6}. As seen from these results, extremely fine, acute projections were formed. The individual projections on the same substrate had much the same shape and the height uniformity of the projections was within ±5%. Therefore, the high-accuracy carbonaceous material projections were formed with little variation in height. The diamond projections formed were of much the same shape, independent of whether the resist mask was etched off or left in the etching.

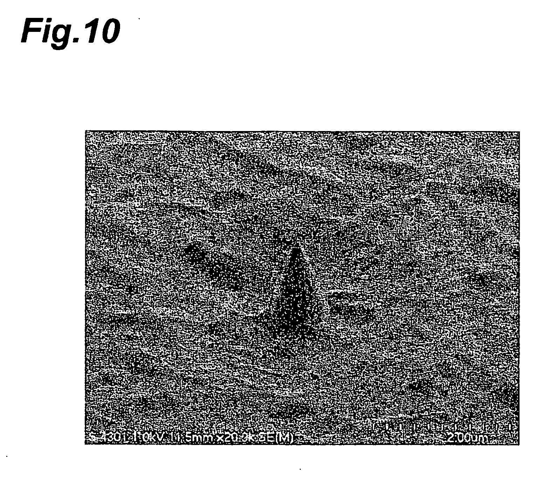

On the other hand, where SiO₂ was used as a mask, not so sharp diamond projections were formed as shown in Fig. 10. Fig. 10 shows an SEM photograph showing a diamond projection formed using SiO₂ as a mask.

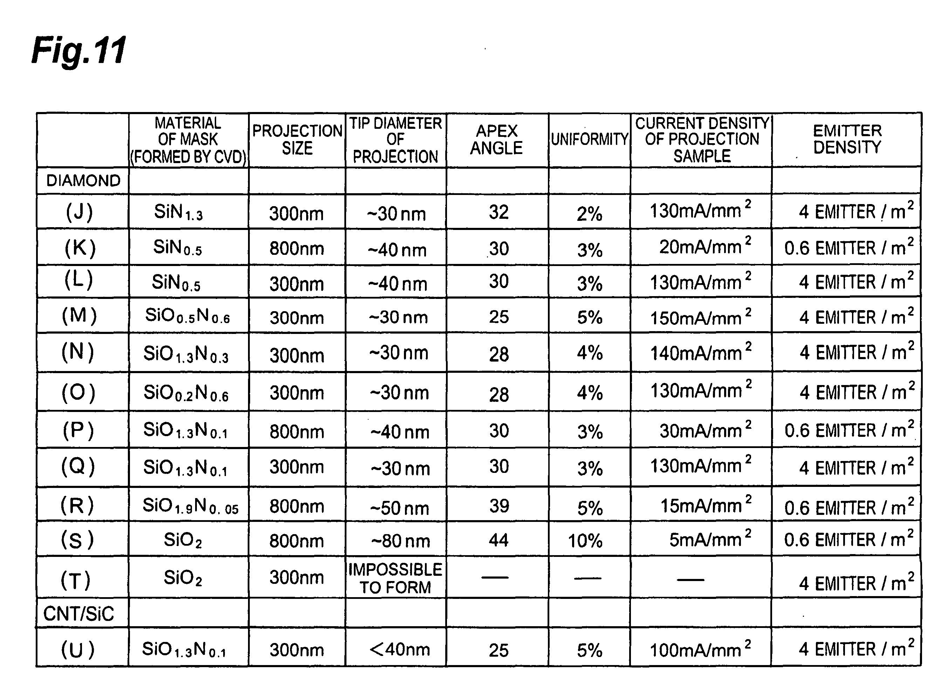

Each of rows (J) to (U) in Fig. 11 shows the material composition of the mask in the present example, the maximum size of the carbonaceous material projections formed using the composition of the mask material (projection size), the tip diameter, the vertex angle (angle at an apex), the uniformity of heights of projections, the current density of emitters, and the projection density (emitter density). As understood from Fig. 11, when Si in material of the mask is slightly nitrided, it becomes easier to form the acute carbonaceous material projections with the vertex angle of not more than 39 degrees. With such acute carbonaceous material projections, the tip diameter is small, not more than 50 nm, and the current density is also large. The acute carbonaceous material projections enable formation of emitters in high density (4 or more emitters/µm²), and it is easy to achieve a high current density with the high-density emitters. In addition, the uniformity of heights of the projections (an error range of heights of the respective projections) can be made small, within ±5%.

### Example 5 (A Reference Example not forming part of the present invention)

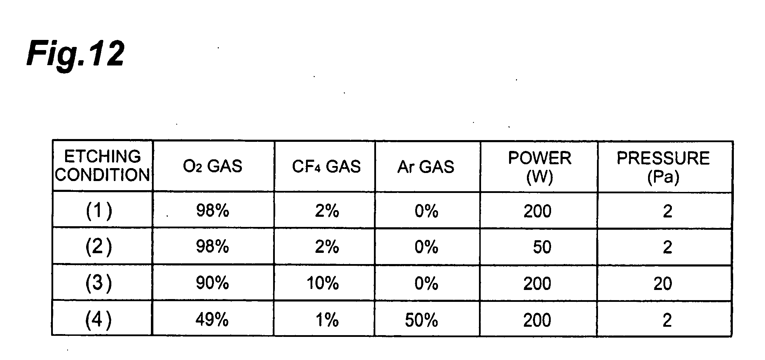

Diamond projections were formed on a diamond substrate by a method similar to that in Example 4. In the formation, etching conditions (1) to (4) shown in Fig. 12 were used for etching diamond, and diamond projections were formed using each of the SiN film and SiON film. In Fig. 12, for example, condition (1) is as follows: the percentage of O₂ gas in the etching gas is 98%, the percentage of CF₄ gas 2%, the percentage of Ar gas 0%, the applied power 200 W, and the pressure 2 Pa. As shown in Fig. 12, diamond projections of extremely acute conical shape were formed by etching of the diamond substrate by RIE (power density: 0.04-0.05 W/mm², pressure: 1-20 Pa) with O₂ and CF₄ gas (CF₄/O₂ = 1-10%). In addition, high-accuracy diamond projections were formed with little variation in height as was the case with Example 4.

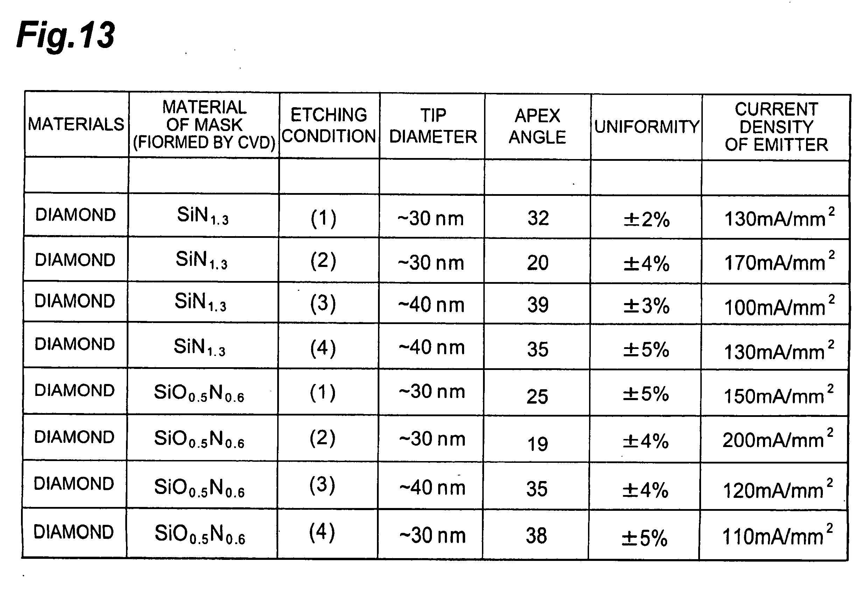

Fig. 13 shows materials for the masks, tip diameters of diamond projections, vertex angles (angles at a vertex), height uniformity of projections, and current densities of emitters. These diamond projections were formed using combinations of mask materials (SiN₁₃, SiO_{0.5}N_{0.6}) and etching conditions (1) to (4). As seen from Fig. 13, by selecting combinations of the mask material and the etching condition, it is feasible to control the vertex angle of the diamond projections and to control the electron emission characteristics of emitters (current density) to desired characteristics. The smaller the vertex angle, the larger the emitter current density tends to be. The emitter density in the present example was 4 emitters/µm² as in the other examples, in each of the combinations of the mask materials and the etching conditions shown in Fig. 13.

Having described and illustrated the principle of the invention in a preferred embodiment thereof, it is appreciated by those having skill in the art that the invention can be modified in arrangement and detail without departing from such principles. We therefore claim all modifications and variations coming within the scope of the following claims.

## Claims

1. A method of forming one or more carbonaceous material projections, the method comprising the steps of:
applying a resist onto a carbonaceous material substrate;
forming holes in the applied resist, the holes being provided according to a predetermined arrangement, each hole having a wall surface, and the wall surface being inversely tapered from an aperture thereof toward a bottom thereof;
depositing mask material for a mask on the carbonaceous material substrate to form a mask deposition in each hole;
lifting off the mask material deposited on the resist together with the resist; and
etching the carbonaceous material substrate by using the mask deposition as a mask to form one or more carbonaceous material projections.

2. The forming method of the carbonaceous material projection according to claim 1, wherein the carbonaceous material projections have a projected diameter of not more than 300 nm, and a density of the carbonaceous material projections is equal to or more than 4 projections/µm².

3. The forming method of the carbonaceous material projection according to claim 1 or 2, wherein each carbonaceous material projection is of a conical shape.

## Patentansprüche

1. Verfahren zur Bildung eines oder mehrerer kohlenstoffhaltiger Materialvorsprünge, wobei das Verfahren folgende Schritte umfasst:
Anwenden einer Schutzschicht auf einen kohlenstoffhaltigen Materialträger;
Bilden von Löchern in der angewandten Schutzschicht, wobei die Löcher gemäß einer vorher bestimmten Anordnung bereitgestellt sind und jedes Loch eine Wandoberfläche aufweist und die Wandoberfläche sich von deren Öffnung zu deren Boden hin konisch verbreitert;
Abscheiden eines Maskenmaterials für eine Maske auf dem kohlenstoffhaltigen Materialträger zur Bildung einer Maskenabscheidung in jedem Loch;
Abheben des auf der Schutzschicht abgeschiedenen Maskenmaterials zusammen mit der Schutzschicht; und
Ätzen des kohlenstoffhaltigen Materialträgers unter Verwendung der Abscheidungsmaske als Maske zur Bildung von einem oder mehreren kohlenstoffhaltigen Materialvorsprüngen.

2. Bildungsverfahren des kohlenstoffhaltigen Materialvorsprungs gemäß Anspruch 1, wobei die kohlenstoffhaltigen Materialvorsprünge einen Vorsprungsdurchmesser von nicht mehr als 300 nm aufweisen und eine Dichte der kohlenstoffhaltigen Materialvorsprünge 4 Vorsprünge/µm² oder mehr ist.

3. Bildungsverfahren des kohlenstoffhaltigen Materialvorsprungs gemäß Anspruch 1 oder 2, wobei jeder kohlenstoffhaltige Materialvorsprung eine konische Form aufweist.

## Revendications

1. Procédé de formation d'une ou plusieurs saillies de matériau carboné, le procédé comprenant les étapes consistant :
à appliquer une réserve sur un substrat de matériau carboné ;
à former des trous dans la réserve appliquée, les trous étant fournis selon une disposition prédéterminée, chaque trou présentant une surface de paroi, et la surface de paroi étant inversement conique à partir d'une ouverture de celle-ci vers un fond de celle-ci ;
à déposer un matériau de masque pour un masque sur le substrat de matériau carboné pour former un dépôt de masque dans chaque trou ;
à soulever le matériau de masque déposé sur la réserve avec la réserve ; et
à graver le substrat de matériau carboné en utilisant le dépôt de masque comme un masque afin de former une ou plusieurs saillies de matériau carboné.

2. Procédé de formation de la saillie de matériau carboné selon la revendication 1, dans lequel les saillies de matériau carboné présentent un diamètre faisant saillie d'au plus 300 nm, et une densité des saillies de matériau carboné est égale à ou supérieure à 4 saillies/µm².

3. Procédé de formation de la saillie de matériau carboné selon la revendication 1 ou 2, dans lequel chaque saillie de matériau carboné est d'une forme conique.
